# FASCICULE DE BREVET EUROPEEN

(11) **EP 0 568 422 B1**
(45) Date de publication et mention de la délivrance du brevet: **21.09.1994**
(21) Numéro de dépôt: 93401053.9
(22) Date de dépôt: 22.04.1993
(51) Int. Cl.: G01R 19/165

(54) **Circuit de détection de seuil de tension à trés faible consommation**
Spannungskomparator mit sehr kleinem Verbrauch
Voltage comparator with very low consumption

(30) Priorité: 30.04.1992 FR 9205425
(43) Date de publication de la demande: 03.11.1993
(73) Titulaire: SGS-THOMSON MICROELECTRONICS S.A., 94250 Gentilly (FR)
(72) Inventeur: Fournel, Richard Pierre, F-75116 Paris (FR); Sourgen, Laurent, F-75116 Paris (FR)
(74) Mandataire: Schmit, Christian Norbert Marie

(56) Documents cités:
- FR-A- 2 415 813
- GB-A- 2 045 563
- US-D- 389 726

## Description

L'invention concerne un circuit électronique servant à détecter le dépassement d'un seuil de tension.

Le document FR-A- 2 415 813 décrit un circuit électronique du type susmentionné ayant les caractéristiques du préambule de la revendication 1.

L'application peut être plus particulièrement envisagée pour la surveillance d'un niveau de tension d'alimentation d'un circuit intégré et la délivrance d'un signal lorsque le niveau est dépassé, par le haut ou le bas.

Par exemple, il peut être nécessaire d'inhiber le fonctionnement d'un circuit intégré lorsque sa tension d'alimentation dépasse des valeurs limités, haute ou basse. Le signal produit en cas de détection du dépassement est alors utilisé pour bloquer le fonctionnement du circuit. La raison peut être par exemple que cette tension trop élevée ou trop basse peut entraîner des fonctionnements anormaux et qu'une interruption pure et simple du fonctionnement est préférable à un fonctionnement anormal. On rencontre notamment ce problème dans les applications où le circuit intégré sert à gérer des données confidentielles ou des données représentant une valeur marchande. Cela se produit par exemple dans les cartes à puces dans lesquelles ces données sont stockées dans une mémoire électriquement programmable

C'est pourquoi on a déjà proposé d'incorporer à un circuit intégré un circuit de détection de dépassement de niveau de tension d'alimentation. Mais les circuits habituellement utilisés présentent l'inconvénient de consommer un courant moyen trop important. Ces circuits utilisent en effet en général une branche dans laquelle circule en permanence un courant continu. L'ordre de grandeur de la consommation est de 75 microampères sous 5 volts et il serait souhaitable de la réduire. En particulier pour des applications de carte sans contact, où l'énergie disponible est faible, et pour les cartes insérées dans des matériels embarqués, tels que des radiotéléphones, la tension d'utilisation est de l'ordre de 3 volts et la consommation doit être réduite au minimum.

L'invention propose un circuit pour détecter un dépassement de niveau de tension, circuit qui présente l'avantage d'être très simple, de consommer un courant moyen très faible, et de permettre la détection d'un dépassement de tension, voire même de la tension d'alimentation elle-même.

Selon l'invention, on propose un circuit de détection de dépassement de niveau d'une tension d'entrée, qui comporte au moins une première et une seconde. capacités, et un ensemble d'interrupteurs actionnés successivement et agencés pour :
- dans une première phase appliquer aux bornes de la première capacité la tension d'entrée et appliquer à la grille d'un transistor de détection la tension présente aux bornes de la deuxième capacité, les deux capacités étant isolées l'une de l'autre,
- dans une deuxième phase relier les deux capacités pour charger la deuxième par la première, les capacités étant isolées de l'entrée et de la grille du transistor de détection,

le circuit comportant encore un moyen pour précharger le drain du transistor de détection pendant la première phase, un moyen pour décharger la deuxième capacité pendant la première phase, et un circuit de verrouillage du niveau logique du drain du transistor de détection.

Dans ce circuit, l'état de la sortie bascule dans la première phase si la tension aux bornes de la capacité au début de cette phase (tension égale à une fraction de la tension d'entrée) dépasse un seuil déterminé. Ce seuil est déterminé en fonction de paramètres techniques de construction du circuit, qui sont principalement la tension de seuil du transistor et les caractéristiques des transistors qui composent le circuit de verrouillage.

Le circuit de verrouillage tend à maintenir le niveau logique de précharge du drain du transistor de détection, mais le dépassement de seuil de la tension à détecter rend conducteur le transistor de détection d'une manière prépondérante par rapport à l'action du circuit de verrouillage, inversant le niveau logique du drain. Après basculement, le circuit de verrouillage cesse de tendre à maintenir au niveau logique de précharge le drain du transistor de détection.

D'autres caractéristiques et avantages de l'invention apparaîtront à la lecture de la description détaillée qui suit et qui est faite en références aux dessins annexés dans lesquels :
- la figure 1 représente le mode de réalisation préférentiel de l'invention.
- la figure 2 représente un diagramme temporel des signaux d'horloge utilisés dans le circuit.

On va décrire l'invention à propos d'une réalisation préférée dans laquelle le circuit de l'invention est incorporé à une puce de circuit intégré comportant d'autres circuits, et dans laquelle on cherche à détecter le dépassement d'une valeur limite de la tension d'alimentation Vdd de ce circuit. Mais l'invention n'est pas limitée à ce cas : le circuit peut servir à surveiller d'autres tensions que la tension d'alimentation Vdd.

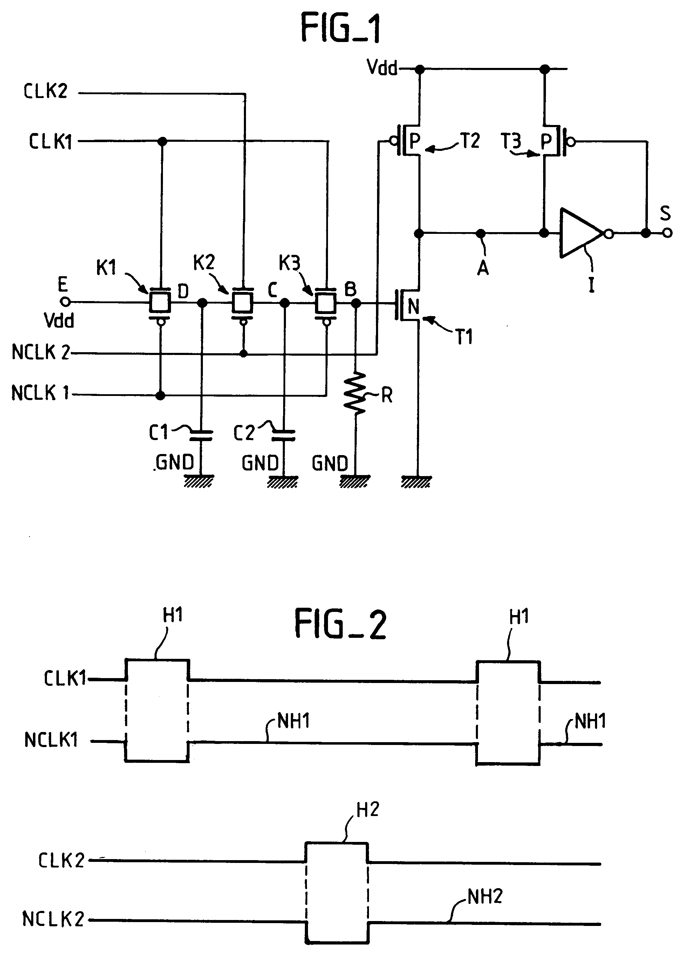

Le mode de réalisation préféré de l'invention est le circuit de la figure 1. Seule la partie de circuit intégré correspondant au circuit de détection selon l'invention est représentée; les autres circuits de la puce ne sont pas représentés et peuvent être quelconques. Le circuit de détection comporte une sortie S qui fournit un niveau logique haut lorsqu'un dépassement de tension maximale autorisée est détecté, et qui reste en permanence au niveau logique bas dans le cas contraire. Le passage de la sortie au niveau haut sert par exemple à inhiber le fonctionnement de tout ou partie du reste du circuit intégré, d'une manière classique et non représentée.

Le circuit de détection est alimenté, comme les autres circuits de la puce, par la tension d'alimentation Vdd, référencée par rapport à une borne de masse GND. La tension Vdd est classiquement de 5 volts environ ou 3 volts.

Le circuit comporte une entrée E qui reçoit la tension à surveiller. Par conséquent, ici, la tension d'alimentation Vdd est appliquée à cette entrée E.

Le circuit comporte trois parties principales. La première a pour fonction l'échantillonnage, de préférence périodique, de la tension appliquée à l'entrée E, et la réduction de cette tension dans un diviseur capacitif en vue d'appliquer la tension échantillonnée réduite à la grille d'un transistor de détection. Quand le fonctionnement n'est pas périodique, l'échantillonnage peut être lié à la séquence réalisée par un microprocesseur du circuit, par exemple en synchronisation avec des opérations de programmation provoquées par ce microprocesseur. La deuxième partie a pour fonction la détection proprement dite et elle utilise pour cela le transistor de détection et un moyen de précharge périodique, ou synchronisé avec la séquence, du drain de ce transistor. La troisième partie a pour fonction le verrouillage du niveau logique de précharge du transistor de détection tant qu'un dépassement de seuil ne se produit pas. Dans la suite de l'exposé on décrira un circuit périodique, mais les signaux de déclenchement peuvent être produits à la demande par un système de synchronisation différent. De plus on retiendra que, si les périodes ne sont pas régulières (en cas de synchronisation), seul le caractère successif alterné des différents signaux est important.

La première partie comporte, dans le mode de réalisation préférentiel, un premier interrupteur K1 reliant l'entrée E à une borne (noeud D) d'une première capacité C1; l'autre borne de la capacité est à la masse GND. L'interrupteur K1 est fermé périodiquement pendant un créneau haut d'horloge H1 ; il est ouvert le reste du temps.

D'une manière classique, l'interrupteur K1 est alors réalisé par une paire de transistors MOS complémentaires en parallèle, commandés l'un (transistor à canal N) par un signal CLK1 d'une première horloge (fournissant les créneaux de tension positive H1) et l'autre (transistor à canal P) par le signal complémentaire NCLK1 de cette première horloge fournissant des créneaux positifs complémentaires NH1.

Un deuxième interrupteur K2, actionné en phase opposée par rapport à l'interrupteur K1, relie une borne (noeud C) d'une deuxième capacité C2 à la première borne (D) de la capacité C1. L'autre borne de C2, comme celle de C1, est à la masse GND.

L'interrupteur K2 est, comme K1, constitué de préférence par une paire de transistors complémentaires, mais cette fois le transistor à canal N est commandé par un signal CLK2 d'une deuxième horloge tandis que le transistor à canal P est commandé par le signal complémentaire NCLK2 de cette deuxième horloge. Les deux horloges sont décalées en phase, comme indiqué sur la figure 2 : le créneau haut H1 de la première horloge étant présent en l'absence du créneau haut H2 de la deuxième horloge et réciproquement.

L'interrupteur K2 est donc passant pendant les créneaux H2, bloqué pendant les créneaux NH2.

Les deux capacités forment un diviseur de tension capacitif dont le rapport de réduction dépend des valeurs respectives des deux capacités.

La première borne de la deuxième capacité (noeud C) est reliée à la grille (noeud B) d'un transistor de détection T1 par un troisième interrupteur K3, constitué comme l'interrupteur K1 et actionné périodiquement, avec la même phase que K1, par les signaux d'horloge CLK1 et NCLK1.

Une résistance R, reliée entre le noeud B et la masse GND permet de décharger progressivement la capacité C2 lorsque l'interrupteur K3 est fermé.

Cette première partie du circuit fonctionne de la manière suivante à chaque période :
- dans une première phase représentée par les créneaux d'horloge H1, la capacité C1 est chargée à la tension Vdd présente sur l'entrée E. Pendant cette première phase, on suppose que la deuxième capacité C2 a le temps de se décharger complètement dans la résistance R à travers l'interrupteur K3;
- dans une deuxième phase, les signaux d'horloge CLK1, CLK2, NCLK1 et NCLK2 ouvrent les interrupteurs K1 et K3 puis ferment l'interrupteur K2. La charge de la capacité C1 se répartit entre les deux capacités C1 et C2 proportionnellement à leur valeur. La tension aux bornes de la capacité C2 prend une valeur Vdd.C1/(C1+C2). C'est cette tension qui sera appliquée par l'interrupteur K3 au transistor de détection T1 lors de la première phase de la période d'échantillonnage suivante.

On notera que les créneaux d'horloge H1 et H2 ne doivent pas se recouvrir au niveau logique haut, c'est-à-dire que le créneau H1 doit revenir au niveau bas juste avant que le créneau H2 ne passe au niveau haut. La figure 2 représente les diagrammes d'horloge correspondants. On remarquera aussi que les créneaux peuvent être (et sont même de préférence) dissymétriques, les créneaux H1 ou H2 étant plus courts que les créneaux NH1 ou NH2 pour minimiser le temps pendant lequel une consommation de courant est prélevée sur l'alimentation.

La deuxième partie du circuit selon l'invention comporte plus précisément le transistor de détection T1 et la résistance R, et un transistor de précharge T2. La grille de T1 est reliée au noeud B, la source est reliée à la masse GND, et le drain est relié à un noeud A qui peut être préchargé à un potentiel déterminé (de préférence tout simplement Vdd) par le transistor T2. Le transistor T1 est ici un transistor à canal N.

Le transistor T2 de précharge est alors de préférence un transistor à canal P ayant son drain relié au noeud A, sa source à la tension d'alimentation Vdd et sa grille commandée par le signal d'horloge NH2. Le noeud A est préchargé à Vdd pendant la deuxième phase (créneaux H2). Selon la tension appliquée à la grille de T1 pendant la première phase suivante, le potentiel du noeud A baissera plus ou moins et fera ou non basculer le niveau logique de la sortie S du circuit.

La troisième partie du circuit selon l'invention comprend le circuit de verrouillage du niveau logique haut du noeud A. Cette partie comporte d'une part un inverseur I dont l'entrée est reliée au noeud A et dont la sortie constitue la sortie S du circuit de l'invention, et d'autre part un transistor de rebouclage T3 servant à verrouiller l'état logique haut du noeud A.

Le transistor de rebouclage T3 est, dans ce mode de réalisation, un transistor à canal P dont le drain est relié au noeud A, dont la source à la tension Vdd, et dont la grille est commandée par la sortie S de l'inverseur I. On comprend que si le noeud A est à un niveau logique haut, la sortie S de l'inverseur est au niveau bas et rend conducteur le transistor T3, confirmant le niveau logique haut du noeud A. Au contraire, si le noeud A passe au niveau bas, le transistor T3 se bloque et n'agit plus sur le noeud A.

La deuxième et la troisième parties du circuit selon l'invention fonctionnent de la manière suivante : lors de la deuxième phase de chaque période d'échantillonnage, le noeud A est préchargé à Vdd (niveau logique haut). Le circuit de verrouillage confirme ce niveau et met la sortie S au niveau logique bas. Puis, à la première phase de la période suivante le transistor de précharge T2 est bloqué et n'intervient plus, mais le transistor de verrouillage T3 maintient l'état logique haut du noeud A. La tension de la capacité C2 est pendant ce temps appliquée au noeud B, c'est-à-dire à la grille du transistor de détection T1.

Il y a alors conflit entre le transistor T3 qui tend à maintenir le noeud A au niveau logique haut et le transistor T1 qui tend à devenir conducteur du fait de la tension appliquée à sa grille. Selon la valeur de la tension appliquée à la grille, c'est-à-dire selon la tension d'entrée E échantillonnée à la phase précédente, le transistor T1 deviendra ou ne deviendra pas suffisamment conducteur pour faire baisser le potentiel du noeud A jusqu'au niveau logique bas permettant de faire basculer l'inverseur I.

Si l'inverseur ne bascule pas, le transistor T3 continue à jouer son rôle de circuit de verrouillage du niveau haut du noeud A. La sortie S reste au niveau logique bas. Si l'inverseur bascule, la sortie passe à l'état haut; le transistor T3 se bloque; le noeud A devient isolé de la tension Vdd (T3 et T2 bloqués); son potentiel ne peut pas remonter et l'état logique de la sortie S reste au niveau haut jusqu'à la phase de précharge suivante. On obtient donc, en cas de dépassement de seuil de la tension d'entrée, une impulsion de sortie dont la durée est liée au décalage entre les deux horloges.

On voit qu'on a ainsi réalisé un détecteur à seuil dont le seuil dépend
- du rapport des capacités C1 et C2 (mais avec des correctifs liés à la présence de capacités parasites éventuelles dans le circuit),
- des dimensions relatives du transistor T1 et du transistor T3, puisque le transistor T1 doit pouvoir tirer le potentiel du noeud A vers le bas malgré l'influence contraire du transistor T3,
- des dimensions relatives des transistors d'entrée de l'inverseur I puisque le seuil de basculement de l'inverseur dépend des caractéristiques de ses transistors d'entrée.

Le rôle de la résistance R est de permettre que la la capacité C2 soit complètement déchargée à la fin de la première phase. Il y a donc un compromis à réaliser entre une valeur suffisamment faible de R pour obtenir une décharge complète avant la fin de la première phase et une valeur suffisamment élevée pour que le transistor T1 soit franchement rendu conducteur en cas de dépassement de la limite de tension acceptée, avant que la capacité C2 ne soit trop déchargée.

Il est souhaitable que le transistor T3 de verrouillage soit aussi peu conducteur que possible (transistor "long" ayant un rapport longueur de canal/largeur de canal très faible, par exemple de 2 micromètres/100 micromètres) pour réduire la consommation du circuit et pour autoriser le basculement de niveau du noeud A sous l'influence du transistor T1. Ce dernier transistor T1 est de préférence petit pour donner une bonne précision de mesure.

Par exemple, ses dimensions sont de : largeur 2 micromètres et longueur 2 micromètres afin de minimiser la division capacitive parasite entre C2 et la capacité de grille de T2. En effet, la tension appliquée instantanément à la grille de T1 est fonction de C2 et de la capacité de grille de T1.

Il est souhaitable que les noeuds B, C, et D présentent des capacités parasites pas trop élevées. Par contre la capacité parasite du noeud A n'est pas gênante car elle permettrait, en étant plus grande, de diminiuer le rapport W/L de T3 et donc la consommation.

On a ainsi décrit un circuit de détection de dépassement de seuil de tension. Ce circuit ne consomme que peu de courant. En particulier, si les horloges CLK et NCLK sont dissymétriques, c'est-à-dire plus précisément si les créneaux logiques hauts H sont plus courts que les créneaux logiques hauts NH, la consommation est réduite. En effet, un facteur de consommation de courant est la durée pendant laquelle le transistor T1 et le transistor T3 sont simultanément conducteurs (la conduction de T1 étant insuffisante dans le cas général pour faire basculer le noeud A mais étant quand même une conduction partielle). La seule limite à la durée des créneaux H est qu'ils doivent être suffisamment longs pour que la capacité C2 soit totalement déchargée à la fin du créneau, alors que la résistance R doit pourtant être assez élevée pour maintenir la conduction du transistor T1 un temps suffisant pour produire le basculement de niveau du noeud A en cas de dépassement de seuil jusqu'à blocage du transistor T3. L'horloge H peut être une horloge à fréquence relativement basse (quelques dizaines de kilohertz par exemple).

## Revendications

1. Circuit de détection de dépassement de niveau d'une tension d'entrée, comportant au moins une première et une seconde capacités (C1, C2), et un ensemble d'interrupteurs (K1, K2, K3), caractérisé en ce que les interrupteurs sont actionnés successivement et agencés pour :
- dans une première phase (H) appliquer aux bornes de la première capacité (C1) la tension d'entrée et appliquer à la grille d'un transistor de détection (T1) la tension présente aux bornes de la deuxième capacité (C2), les deux capacités étant isolées l'une de l'autre,
- dans une deuxième phase relier les deux capacités pour charger la deuxième par la première, les capacités étant isolées de l'entrée (E) et de la grille du transistor de détection,
le circuit comportant encore un moyen (T2) pour précharger le drain du transistor de détection (T1) pendant la première phase, un moyen (R) pour décharger la deuxième capacité pendant la première phase (H), et un circuit de verrouillage (I, T3) du niveau logique du drain du transistor de détection.

2. Circuit de détection de dépassement selon la revendication 1, caractérisé en ce que le circuit de verrouillage comprend un inverseur (I) ayant son entrée reliée au drain du transistor de détection, sa sortie (S) constituant une sortie du circuit de détection de dépassement, et un transistor de rebouclage (T3) commandé par la sortie de l'inverseur et relié au drain du transistor de détection.

3. Circuit selon la revendication 2, caractérisé en ce que le transistor de rebouclage est un transistor à canal P ayant sa source reliée à une tension d'alimentation (Vdd) et son drain relié au drain du transistor de détection.

4. Circuit selon l'une des revendications 1 à 3, caractérisé en ce qu'il comporte une horloge dissymétrique (CLK, NCLK) fournissant des créneaux de durées différentes pour la première et la deuxième phase.

5. Circuit selon la revendication 4, caractérisé en ce que l'horloge fournit des créneaux plus courts pour la première phase que pour la deuxième.

6. Circuit selon l'une des revendications 4 et 5, caractérisé en ce que les créneaux périodiques fournis par l'horloge pour la première phase n'ont pas de recouvrement avec les créneaux périodiques fournis pour la deuxième phase.

7. Circuit selon l'une des revendications 1 à 6, caractérisé en ce que l'entrée (E) est reliée à une borne d'alimentation en tension (Vdd) du circuit.

8. Circuit selon l'une des revendications précédentes, caractérisé en ce qu'il est incorporé à une puce de circuit intégré et en ce qu'il comporte une sortie apte à inhiber le fonctionnement d'autres circuits placés sur la même puce, en cas de dépassement d'un seuil de tension sur l'entrée du circuit de détection ou de la détection d'un seuil bas.

## Patentansprüche

1. Spannungskomparator für die Feststellung des Abweichens vom Niveau einer Eingangsspannung, umfassend zumindest einen ersten und einen zweiten Kondensator (C1, C2) und eine Schalteranordnung (K1, K2, K3), dadurch gekennzeichnet, daß die Schalter nacheinander betätigt werden und eingerichtet sind für:
- das Anlegen einer Eingangsspannung an die Anschlüsse des ersten Kondensators (C1) und das Anlegen der an den Anschlüssen des zweiten Kondensators (C2) vorhandenen Spannung an das Gate eines Erfassungstransistors (T1) während einer ersten Phase (H), wobei die beiden Kondensatoren gegeneinander isoliert sind,
- das Verbinden der beiden Kondensatoren während einer zweiten Phase, um den zweiten durch den ersten aufzuladen, wobei die Kondensatoren gegenüber dem Eingang (E) und dem Gate des Erfassungstransistors isoliert sind,
wobei der Komparator auch noch ein Mittel (T2) für das Voranlegen einer Spannung an den Drain des Erfassungstransistors (T1) während der ersten Phase, ein Mittel (R) für das Entladen des zweiten Kondensators während der ersten Phase (H) und eine Klemmschaltung (I, T3) zum Klemmen des logischen Pegels des Drain des Erfassungstransistors umfaßt.

2. Spannungskomparator nach Anspruch 1, dadurch gekennzeichnet, daß die Klemmschaltung einen Inverter (I), dessen Eingang mit dem Drain des Erfassungstransistors verbunden ist, wobei sein Ausgang (S) einen Ausgang des Komparators bildet und einen Rückkopplungstransistor (T3) umfaßt, der durch den Ausgang des Inverters steuerbar ist und mit dem Drain des Erfassungstransistors verbunden ist.

3. Spannungskomparator nach Anspruch 2, dadurch gekennzeichnet, daß der Rückkopplungstransistor ein Transistor mit einem P-Kanal ist, deren Source mit einer Speisespannung (Vdd) beaufschlagt ist und dessen Drain mit dem Drain des Erfassungstransistors verbunden ist.

4. Spannungskomparator nach einem der Ansprüche 1 bis 3, dadurch gekennzeichnet, daß er einen Taktgeber (CLK, NCLK) mit fehlender Symmetrie umfaßt, der unterschiedlich lange Impulse für die erste und die zweite Phase liefert.

5. Spannungskomparator nach Anspruch 4, dadurch gekennzeichnet, daß der Taktgeber für die erste Phase kürzere Impulse als für die zweite Phase liefert.

6. Spannungskomparator nach Anspruch 4 und 5, dadurch gekennzeichnet, daß die durch den Taktgeber gelieferten periodischen Impulse für die erste Phase keine Überdeckung mit den für die zweite Phase gelieferten periodischen Impulse aufweisen.

7. Spannungskomparator nach einem der Ansprüche 1 bis 6, dadurch gekennzeichnet, daß der Eingang (E) mit einem Speisespannungsanschluß (Vdd) des Spannungskomparator verbunden ist.

8. Spannungskomparator nach einem der vorhergehenden Ansprüche, dadurch gekennzeichnet, daß er in einem Chip einer integrierten Schaltung eingegliedert ist und daß er einen Ausgang aufweist, der geeignet ist die Funktion anderer Schaltungen, die auf dem gleichen Chip angeordnet sind, zu hemmen und zwar für den Fall der Überschreitung einer Spannungsschwelle am Eingang des Spannungskomparators oder bei der Feststellung einer niedrigen Schwelle.

## Claims

1. Circuit for detecting that an input voltage level has been exceeded, including at least a first and a second capacitor (C1, C2) and a set of switches (K1, K2, K3), characterised in that the switches are actuated in succession and arranged so as:
- in a first phase (H), to apply the input voltage to the terminals of the first capacitor (C1) and to apply the voltage present at the terminals of the second capacitor (C2) to the gate of a detector transistor (T1), the two capacitors being isolated from each other,
- in a second phase, to connect the two capacitors in order to charge the second by means of the first, the capacitors being isolated from the input (E) and from the gate of the detector transistor,
the circuit also including a means (T2) for precharging the drain of the detector transistor (T1) during the first phase, a means (R) for discharging the second capacitor during the first phase (H), and a circuit (I, T3) for clamping the logic level of the drain of the detector transistor.

2. Circuit for detecting exceeding according to Claim 1, characterised in that the clamping circuit comprises an inverter (I) having its input connected to the drain of the detector transistor, its output (S) constituting an output of the circuit for detecting exceeding, and a feedback transistor (T3) controlled by the output of the inverter and connected to the drain of the detector transistor.

3. Circuit according to Claim 2, characterised in that the feedback transistor is a p-channel transistor having its source connected to a supply voltage (Vdd) and its drain connected to the drain of the detector transistor.

4. Circuit according to one of Claims 1 to 3, characterised in that it includes an asymmetric clock (CLK, NCLK) supplying square waves of different durations for the first and second phases.

5. Circuit according to Claim 4, characterised in that the clock supplies shorter square waves for the first phase than for the second.

6. Circuit according to one of Claims 4 and 5, characterised in that the periodic square waves supplied by the clock for the first phase do not overlap with the periodic square waves supplied for the second phase.

7. Circuit according to one of Claims 1 to 6, characterised in that the input (E) is connected to a terminal supplying a voltage (Vdd) to the circuit.

8. Circuit according to one of the preceding claims, characterised in that it is incorporated in an integrated-circuit chip and in that it includes an output suitable for inhibiting the functioning of other circuits placed on the same chip in the event of a voltage threshold being exceeded at the input of the detector circuit or a low threshold being detected.
